(19) Europäisches Patentamt — European Patent Office — Office européen des brevets

(11) **EP 4 729 952 A1**

(12) **DEMANDE DE BREVET EUROPEEN**

(43) Date de publication:
**22.04.2026   Bulletin 2026/17**

(21) Numéro de dépôt: **25204836.8**

(22) Date de dépôt: **26.09.2025**

(51) Classification Internationale des Brevets (IPC):
***G01R 25/00*** *(2006.01)*

(52) Classification Coopérative des Brevets (CPC):
**G01R 25/005**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **16.10.2024   FR 2411233**

(71) Demandeur: **Commissariat à l'Energie Atomique et aux Energies Alternatives**
**75015 Paris (FR)**

(72) Inventeur: **CABANILLAS, Esteban**
**38054 Grenoble Cedex 09 (FR)**

(74) Mandataire: **Atout PI Laplace**
**Immeuble Up On**
**25 Boulevard Romain Rolland**
**CS 40072**
**75685 Paris Cedex 14 (FR)**

(54) **PROCÉDÉ DE MESURE DE LA PHASE D'UNE IMPÉDANCE COMPLEXE ET APPAREIL DE MESURE**

(57)     L'invention concerne un procédé de mesure de la phase d'une impédance complexe d'un élément électrique (EL), comprenant les étapes suivantes :
- appliquer à l'élément électrique un signal d'excitation ($S_{ex}$);
- acquérir un premier signal analogique ($u_V$);
- acquérir un deuxième signal analogique ($u_I$);
- numériser le premier signal analogique en un premier signal numérique ($\overline{U}_V$) et le deuxième signal analogique en un second signal numérique ($\overline{U}_I$);
- injecter le premier signal numérique en entrée d'enclenchement d'un premier convertisseur temps-numérique et en entrée de déclenchement d'un second convertisseur temps-numérique ;
- injecter le second signal numérique en entrée de déclenchement du premier convertisseur temps-numérique et en entrée d'enclenchement du second convertisseur temps-numérique ;
- déterminer une première valeur de retard $t_1$ et une seconde valeur de retard $t_2$;
- calculer la valeur de la phase de l'impédance complexe de l'élément électrique.

[Fig. 5]

EP 4 729 952 A1

**Description**

L'invention se situe dans le domaine de l'instrumentation électronique. Elle porte plus particulièrement sur un procédé et un appareil de mesure d'une impédance complexe d'un élément électrique.

La notion d'impédance complexe généralise celle de résistance pour des signaux sinusoïdaux à une fréquence f donné. Dans le cas d'un dipôle électrique, l'impédance complexe Z est définie par $Z = \dfrac{U}{I}$ où U est le phaseur (nombre complexe) représentant l'amplitude et la phase de la tension aux bornes du dipôle et I le phaseur représentant l'amplitude et la phase du courant le traversant. Plus généralement, dans le cas d'un circuit à N ports (le dipôle correspondant au cas N=1) on peut définir une impédance $Z_{ij} = \left.\dfrac{U_i}{I_j}\right|_{I_k=0, k \neq j}$. Autrement dit, l'impédance $Z_{ij}$ est le rapport (complexe) entre le phaseur représentant la tension aux bornes du port « i » et le phaseur représentant le courant entrant dans (ou sortant de, en fonction de la convention adoptée) le port « j » lorsque le courant entrant dans tous les autres ports est nul. Les différents termes $Z_{ij}$ forment la matrice impédance de l'élément multiport. Dans la suite, le terme d'impédance et le symbole « Z » seront utilisés pour désigner tant l'impédance d'un dipôle qu'un terme $Z_{ij}$ de la matrice impédance d'un multiport.

Etant un nombre complexe, l'impédance Z d'un élément électrique peut se décomposer en une partie réelle et une partie imaginaire - Z=R+jX, où « j » désigne ici l'unité imaginaire - ou en module et en phase : $Z = |Z|e^{j\varphi}$, où |Z| est le rapport entre les valeurs efficaces de la tension et du courant et φ leur déphasage. La phase de l'impédance correspond au retard existant entre la tension aux bornes de l'élément électrique et le courant traversant l'élément électrique.

D'une manière générale, l'impédance varie avec la fréquence des signaux électriques considérés. Pour caractériser un élément électrique, il est donc nécessaire de mesurer son (ou ses) impédance(s) dans une bande de fréquence plus ou moins étendue. On écrit donc Z(f), |Z(f)| et φ(f) pour désigner, respectivement, une impédance complexe, son module et sa phase en fonction de la fréquence f (ou de manière équivalente en fonction de sa période T= 1 /f).

Plusieurs techniques ont été développées pour mesurer la phase de l'impédance, φ(f), d'un élément électrique en fonction de la fréquence.

Parmi les méthodes connues de l'art antérieur, le retard $\hat{t}(f)$ (ou le déphasage φ(f), si multiplié par 2π/T) entre les signaux numérisés $\overline{U}_V$ et $\overline{U}_I$ de la tension $u_v$ aux bornes de l'élément électrique et du courant $u_i$ le traversant est mesuré à partir d'un convertisseur numériques de retard (TDC ou « Time-to-Digital Converter » selon l'appellation anglo-saxonne couramment utilisée) comprenant N élément de retard, où chaque élément de retard a un temps de transition $\tau$.

Cette architecture de TDC est une architecture conventionnelle pouvant facilement être mise en place, tout particulièrement dans des systèmes basés sur des réseaux de portes programmables sur site (FPGA ou « Field-Programmable Gate Array » selon l'appellation anglo-saxonne couramment utilisée).

La complexité de l'intégration de TDC dans un FPGA est fonction de multiples facteurs:

- Le temps de transition $\tau$ de l'élément logique de la ligne de retardement. Une valeur de $\tau$ petit permet de réaliser des mesures de temps très précises, mais peut induire à une intégration du TDC trop complexe si la dynamique de temps à mesurer est beaucoup plus grande que $\tau$. La valeur minimale de $\tau$ est définie par la technologie du FPGA ciblée.

- La fréquence maximale $f_{max}$ à générer pour effectuer le balayage en fréquence pour la mesure de phase de l'impédance. Une fréquence élevée donne des valeurs de période faibles, et donc, des petits retards à mesurer, ce qui demande une valeur de $\tau$ très petite pour des mesures précises. La précision dans l'estimation de φ(f) sera donc déterminée par le FPGA utilisé.

- la fréquence minimale $f_{min}$ à générer pour effectuer le balayage en fréquence pour la mesure de phase de l'impédance. Une basse fréquence est associée à des périodes élevées et donc, pour une mesure de phase à dynamique complète (0-2π), à un TDC très complexe en termes du nombre d'élément de retard et de bascules.

Il est donc nécessaire de trouver un compromis entre la dynamique de mesure ($f_{max}$ - $f_{min}$) et la résolution du TDC déterminé par la valeur $\tau$.

Pour mesurer une plage de phase de 0 à 2π, il est nécessaire de concevoir une ligne de retardement comprenant un grand nombre d'éléments de retard. Une intégration FPGA présente en conséquence des phénomènes de dispersion importants dus à la non-uniformité des cellules logiques et au routage interne du FPGA des signaux et des blocs.

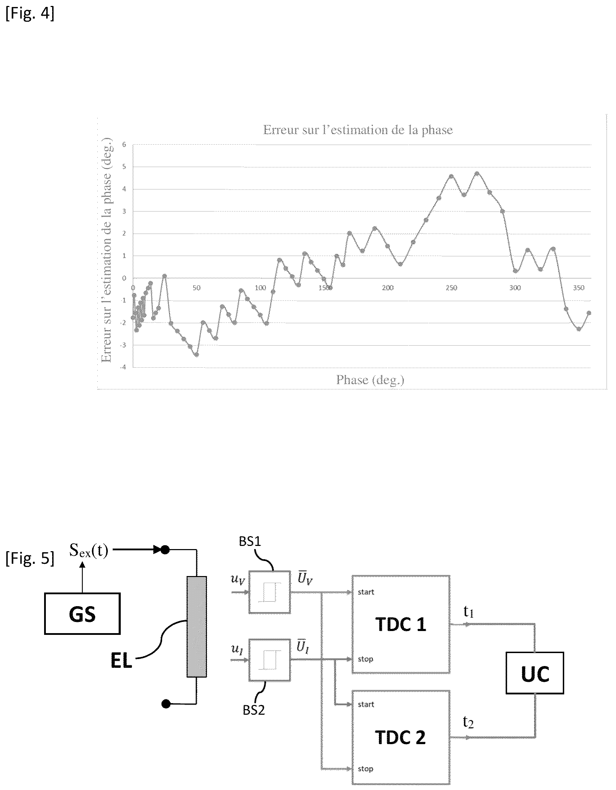

L'erreur Δφ(f) sur l'estimation de la phase présente également une forte asymétrie par rapport à la phase estimée (voir la [Fig. 4]), ce qui est handicapant pour les algorithmes de post-traitement.

Le document US 7 932 847 B1 divulgue un appareil pour recevoir un premier signal d'entrée et un second signal d'entrée et pour générer une sortie numérique correspondant à une différence de temps entre le premier signal d'entrée et le second signal d'entrée.

(Mattada et al. 2021) propose un système permettant de diminuer l'erreur sur l'estimation de la phase en ayant recours à des TDC complexes, conçus à partir de multiples compteurs boucle à phase asservie (PLL ou « Phase Locked Loop » selon l'appellation anglo-saxonne couramment utilisée) et de compteurs boucle à verrouillage de retard (DLL ou « Delay Locked Loop » selon l'appellation anglo-saxonne couramment utilisée).

De plus, aucun document de l'art antérieur ne traite les imperfections donnant une asymétrie de l'erreur d'estimation de la phase.

Il existe donc un besoin pour rendre symétrique et faible l'erreur d'estimation de la phase dans le cadre d'une intégration de TDC conventionnels dans un FPGA.

D'autres caractéristiques, détails et avantages de l'invention ressortiront à la lecture de la description faite en référence aux dessins annexés donnés à titre d'exemple et qui représentent, respectivement :

[Fig.1], le schéma fonctionnel d'un appareil de mesure ne relevant pas de l'invention ;

[Fig. 2], une illustration du principe de fonctionnement de l'appareil de la [Fig. 1] ;

[Fig. 3] est un schéma fonctionnel d'un dispositif de mesure de phase à partir d'un TDC basé sur une ligne de retardement;

[Fig. 4] est un graphique illustrant la dépendance de ladite erreur de mesure de phase en fonction de la phase de l'impédance complexe mesurée.

[Fig. 5] est un schéma fonctionnel d'un appareil de mesure selon un mode de réalisation de l'invention ;

[Fig. 6] est un schéma fonctionnel d'un appareil de mesure selon un autre mode de réalisation de l'invention ;

Dans les algorithmes présents dans la suite de la description, le symbole « & » est équivalent à l'opérateur logique « ET », le symbole « | » est équivalent à l'opérateur logique « OU ».

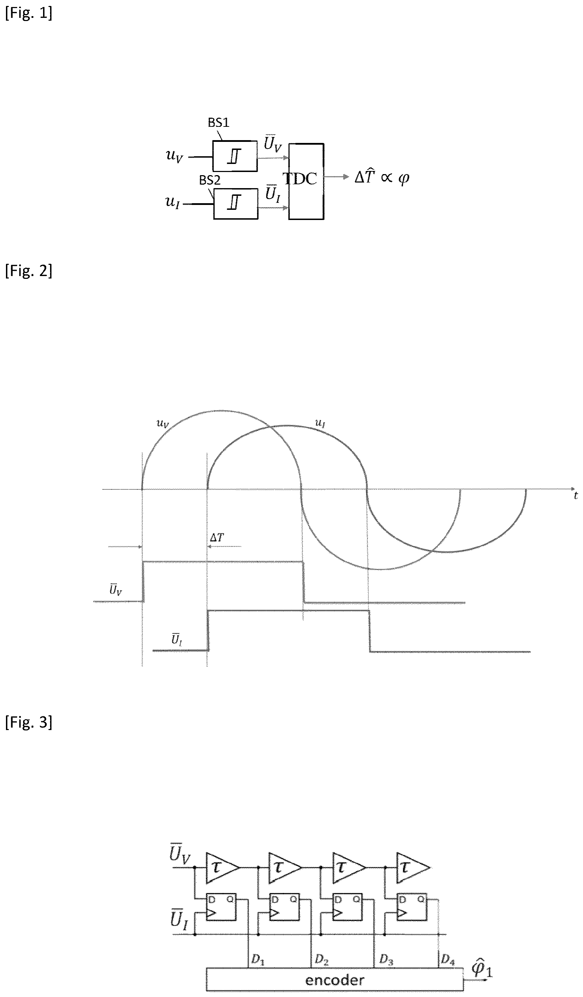

La [Fig. 1] est le schéma fonctionnel d'un hypothétique appareil de mesure permettant, en principe, de mesurer le déphasage entre deux signaux analogiques sinusoïdaux $u_v$ et $u_i$. Si ces deux signaux sont représentatifs, respectivement, de la tension aux bornes d'un élément électrique et du courant le traversant, cette mesure de déphasage permet de déterminer la phase de l'impédance complexe de l'élément.

L'appareil de la [Fig. 1] comprend deux bascules de Schmitt BS1, BS2 présentant deux tensions de seuil $V_{LH}$>0 V et $V_{HL}$<0V. La sortie d'une bascule de Schmitt devient haute lorsque le signal à son entrée dépasse $V_{LH}$, puis se maintient haute tant que ledit signal de descend en dessous de $V_{HL}$. Pour $V_{LH} \rightarrow 0$ V et $V_{HL} \rightarrow 0$V, la bascule de Schmitt devient un simple comparateur à zéro. Si un tel comparateur était utilisé, le bruit électronique induirait des commutations multiples et aléatoires lors d'un passage par zéro du signal d'entrée ; pour cette raison on préfère généralement utiliser des bascules de Schmitt - dites aussi comparateurs à hystérésis - avec une hystérésis $\Delta V = V_{LH} - V_{HL}$ du même ordre de grandeur que l'amplitude de pic du bruit affectant le signal d'entrée.

Les bascules de Schmitt convertissent les signaux sinusoïdaux d'entrée $u_v$ et $u_i$ en deux signaux en créneaux $\overline{U}_V$ et $\overline{U}_I$ respectivement. Un convertisseur temps - numérique TDC (« time-to-digital converter » en anglais) reçoit en entrée ces signaux et fournit à sa sortie une valeur numérique $\Delta \hat{T}$ qui constitue une estimation du décalage temporel $\Delta T$ entre les fronts montants (ou, de manière équivalente, les fronts descendants) de ces signaux. Comme on peut le voir sur la [Fig. 2], ce décalage temporel est à son tour proportionnel au déphasage $\varphi$ entre les deux signaux analogiques d'entrée $u_v$ et $u_i$. Aussi, la sortie numérique du convertisseur TDC constitue (à un facteur multiplicatif près, égal à la fréquence $f$ des signaux d'entrée) une estimation $\hat{\varphi}$ de ce déphasage.

Le principe de fonctionnement d'un TDC consiste à mesurer, en multiples d'unités de temps $\tau$, le retard entre les signaux $\overline{U}_V$ et $\overline{U}_I$. Pour cela, le signal $\overline{U}_V$ est injecté dans une ligne de retardement comprenant N éléments de retard, où chaque élément de retard a un temps de transition $\tau$, comme on peut le voir sur la [Fig. 3]. Cet élément de retard peut être mis en place à partir d'une porte logique (par exemple NOT, OR, AND) ou d'un bloc arithmétique (par exemple additionneur, multiplieur), ou tout autre bloc logique asynchrone à retard fixe. La mesure de temps est réalisé à l'instant d'occurrence du front montant de $\overline{U}_I$. A cet instant, l'état en sortie de chaque élément de retard est enregistré en sortie des bascules. Le retard $\hat{t}$ entre les fronts montants de $\overline{U}_V$ et $\overline{U}_I$ est approximé par $\hat{t} = N\tau$, avec $N$ la position de la bascule où se produit une transition de valeur de sortie de '1' logique à '0' logique. La fréquence $\varphi(f)$ est estimée grâce à la connaissance à priori de la fréquence (et la période) du signal $u_v$, qui est généré par le système de mesure.

Pour un TDC intégré dans un FPGA du type Xilinx ZYNQ 7010, l'élément de retard est un additionneur 2 bits avec retenue, avec un temps de transition $\tau$=585ps. Le TDC est conçu pour fonctionner à des fréquences allant de 6MHz à 10MHz. Avec une fréquence minimale autour de 6MHz (période T=166ns), il est nécessaire d'intégrer une ligne à retardement d'environ 300 éléments pour pouvoir mesurer une plage de phase de 0 à $2\pi$. Comme expliqué ci-avant, une telle intégration FPGA est liée à des phénomènes de dispersion importants dues à la non uniformité des cellules logiques et au routage interne du FPGA des signaux et blocs.

Pour un temps de transition $\tau$=585 ps et un signal injecté $\overline{\overline{U_V}}$ à une fréquence $f$=8,5 MHz, la résolution donnée par le temps de transition $\tau$ représente une phase de 1.8°. Comme le montre la [Fig. 4], dans cette configuration, l'erreur est inférieure à la résolution pour l'intervalle de mesure sur l'intervalle [0°-40°]. Par la suite, la dispersion génère une erreur de 2 fois la résolution sur l'intervalle [40°-250°]. Sur l'intervalle [250°-360°], l'erreur est supérieure à 3 fois la résolution.

Une idée à la base de l'invention est qu'un TDC différent pour chaque intervalle de phase peut être utilisé pour réduire l'erreur sur l'estimation de la phase.

La [Fig. 5] illustre le schéma fonctionnel d'un appareil selon un premier mode de réalisation de l'invention, mettant en œuvre ce principe.

Sur la [Fig. 5], la référence EL représente un élément électrique (plus particulièrement, un dipôle, comprenant deux bornes formant un seul port) dont la phase de l'impédance complexe doit être déterminée. Un générateur GS applique un signal d'excitation $s_{ext}(t)$ sinusoïdal, de fréquence $f$ éventuellement variable, aux bornes de l'élément EL. Le signal $s_{ext}(t)$ peut être un signal de courant ou de tension. Le générateur GS fournit également à sa sortie une valeur numérique représentative de la fréquence $f$. Le générateur GS peut, par exemple, être piloté de telle sorte que $f$ balaye, de manière continue ou discrète, une bande spectrale d'intérêt.

L'appareil de la [Fig. 5] reçoit sur un premier port d'entré le premier signal analogique $u_v(t)$ représentatif de la tension aux bornes de l'élément EL et sur un deuxième port d'entré le deuxième signal analogique $u_i(t)$ représentatif du courant traversant ce dernier. Par exemple, le signal $u_v(t)$ peut être directement la tension aux bornes de l'élément EL et $u_i(t)$ une tension aux bornes d'une résistance connectée en série à EL. Les signaux $u_v(t)$ et $u_i(t)$ sont fournis en entrée à des bascules de Schmitt respectives BS1, BS2, qui fournissent en sortie des signaux en créneaux $\overline{U_V}$, $\overline{U_I}$.

La sortie de la première bascule de Schmitt BS1 est reliée à l'entrée d'enclenchement (entrée « START » selon l'appellation anglo-saxonne couramment utilisée) d'un premier convertisseur temps - numérique TDC1 et à l'entrée de déclenchement (entrée « STOP » selon l'appellation anglo-saxonne couramment utilisée) d'un second convertisseur temps - numérique TDC2 de l'appareil de la [Fig. 5]. Préférentiellement, la sortie de la première bascule de Schmitt BS1 est reliée directement à l'entrée d'enclenchement de TDC1 et à l'entrée de déclenchement de TDC2 en ce sens qu'aucun autre dipôle n'est connecté en série entre BS1 et l'entrée d'enclenchement de TDC1, ni entre BS1 et l'entrée de déclenchement de TDC2. Alternativement, un dipôle est connecté en série entre BS1 et l'entrée d'enclenchement de TDC1 ou entre BS1 et l'entrée de déclenchement de TDC2. Le dipôle est par exemple un capteur de courant.

La sortie de la deuxième bascule de Schmitt BS2 est reliée à l'entrée de déclenchement du premier convertisseur temps - numérique TDC1 et à l'entrée d'enclenchement du second convertisseur temps - numérique TDC2. Préférentiellement, la sortie de la deuxième bascule de Schmitt BS1 est reliée directement à l'entrée de déclenchement de TDC1 et l'entrée d'enclenchement de TDC2 en ce sens qu'aucun autre dipôle n'est connecté en série entre BS2 et l'entrée de déclenchement de TDC1, ni entre BS2 et l'entrée d'enclenchement de TDC2. Alternativement, un dipôle est connecté en série entre BS2 et l'entrée de déclenchement de TDC1 ou entre BS2 et l'entrée d'enclenchement de TDC2. Le dipôle est par exemple un capteur de courant.

Le premier convertisseur temps - numérique TDC1 est configuré pour mesurer une valeur de retard $t_1$ entre le front montant du signal numérique injecté en entrée d'enclenchement et le front montant du signal numérique injecté en entrée de déclenchement. De manière équivalente, le premier convertisseur temps - numérique TDC1 est configuré pour mesurer une valeur de retard $t_1$ entre le front descendant du signal numérique injecté en entrée d'enclenchement et le front descendant du signal numérique injecté en entrée de déclenchement.

Le deuxième convertisseur temps - numérique TDC2 est configuré pour mesurer une valeur de retard $t_2$ entre le front montant du signal numérique injecté en entrée de déclenchement et le front montant du signal numérique injecté en entrée d'enclenchement. De manière équivalente, le deuxième convertisseur temps - numérique TDC2 est configuré pour mesurer une valeur de retard $t_1$ entre le front descendant du signal numérique injecté en entrée de déclenchement et le front descendant du signal numérique injecté en entrée d'enclenchement.

L'appareil de la [Fig. 5] comprend également une unité de calcul UC configurée pour calculer la valeur de la phase de l'impédance complexe de l'élément électrique EL, soit en fonction de $t_1$ pour $t_1 \leq S_0$, soit en fonction de $t_2$ pour $S_1 \leq t_1 \leq S_2$, dans lequel $S_0$, $S_1$ et $S_2$ sont trois valeurs seuil, avec $S_0 \leq S_1 \leq S_2$.

Comme expliqué ci-avant, le retard est estimé par la formule $\hat{t} = N\tau$. Lorsque $t_1 \leq S_0$, le retard $\hat{t}$ est égal au temps $t_1$, $t_1$ étant calculé à partir du premier convertisseur temps-numérique TDC1, qui est dans une configuration conventionnelle, celui-ci mesurant une valeur de retard entre le front montant de $\overline{U_I}$ et le front montant $\overline{V_V}$.

Lorsque $S_1 \leq t_1 \leq S_2$, le retard $\hat{t}$ est égal à $(S_2 - t_2)$, $t_2$ étant calculé à partir du deuxième convertisseur temps-numérique TDC2, qui est dans une configuration opposée à celle du premier convertisseur temps-numérique TDC1. Dans cette configuration, le deuxième convertisseur temps-numérique TDC2 mesure une valeur de retard entre le front montant de $\overline{U_V}$ et le front montant de $\overline{U_I}$. Conséquemment, la valeur $N\tau$ mesurée par le deuxième convertisseur temps-numérique TDC2 correspond à la valeur (S2-$\hat{t}$).

De manière préférentielle, $S_0=S_1=T/2$ et $S_2=T$. Pour $t_1 \leq T/2$, le retard $\hat{t}$ est égal au temps $t_1$. Pour $T/2 \leq t_1 \leq T$ ou $t_1=0$, la valeur de retard $\hat{t}$ est égale à $(T-t_2)$. Pour les phases inférieures à 180°, le retard $\hat{t}$ est évalué par le premier convertisseur temps-numérique TDC1 qui mesure le retard du front montant de $\overline{U}_V$ par rapport au front montant $\overline{U}_I$. Pour les phases supérieures à 180°, le retard $\hat{t}$ est évalué par le deuxième convertisseur temps-numérique TDC2 qui mesure le retard du front montant le front montant de $\overline{U}_I$ par rapport au front montant $\overline{U}_V$.

Le convertisseur temps-numérique TDC1 est configuré pour renvoyer une valeur nulle ($t_1=0$) lorsque la valeur de retard mesurée est supérieure à la moitié de la période du premier signal numérique $\overline{U}_V$.

Selon le premier mode de réalisation de l'invention, l'algorithme de mesure pour l'estimation du retard $\hat{t}$ est le suivant :

$$\left(t_1 < \frac{T}{2}\right) \rightarrow \hat{t} = t_1$$

$$\left(t_1 > \frac{T}{2}\right) | (t_1 == 0) \rightarrow \hat{t} = T - t_2$$

Selon le premier mode de réalisation, tous les TDC doivent seulement pouvoir mesurer une valeur de retard allant jusqu'à $T_{max}/2$.

Avantageusement, le retard $t_1$ ou $t_2$ utilisé pour l'évaluation du retard $\hat{t}$ est toujours inférieur à 180° pour une fréquence du premier signal numérique $\overline{U}_V$ égale à $f_{min}$. Le retard t mesuré peut être supérieur à 180° si la fréquence du premier signal numérique $\overline{U}_V$ est supérieure à $f_{min}$. Cela permet de limiter la complexité des TDC utilisés, en particulier en termes de nombre d'éléments de retard, et de diminuer l'erreur sur l'estimation de la phase de l'impédance de l'élément électrique EL. L'invention permet également de rendre plus symétrique en phase l'erreur sur l'estimation de la phase de l'impédance de l'élément électrique EL.

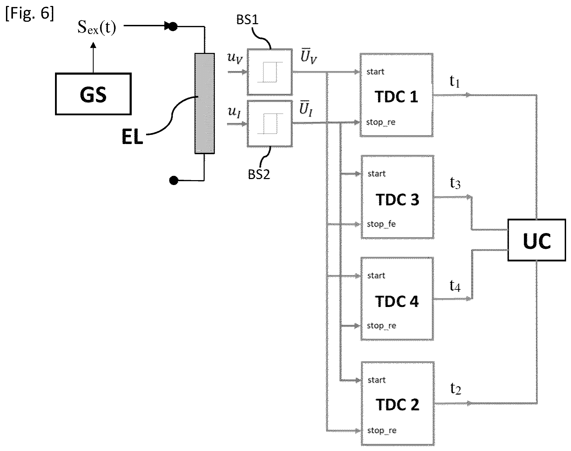

La [Fig. 6] illustre le schéma fonctionnel d'un appareil selon un deuxième mode de réalisation de l'invention, mettant en œuvre ce principe.

Selon ce mode de réalisation, l'appareil comprend également par rapport au premier mode de réalisation un troisième convertisseur temps - numérique TDC3 et un quatrième convertisseur temps - numérique TDC4.

La sortie de la première bascule de Schmitt BS1 est reliée à l'entrée d'enclenchement du quatrième convertisseur temps - numérique TDC4 et à l'entrée de déclenchement du troisième convertisseur temps - numérique TDC3 de l'appareil de la [Fig. 5]. Préférentiellement, la sortie de la première bascule de Schmitt BS1 est reliée directement à l'entrée d'enclenchement de TDC4 et à l'entrée de déclenchement de TDC3 en ce sens qu'aucun autre dipôle n'est connecté en série entre BS1 et l'entrée d'enclenchement de TDC4, ni entre BS1 et l'entrée de déclenchement de TDC3. Alternativement, un dipôle est connecté en série entre BS1 et l'entrée d'enclenchement de TDC4 ou entre BS1 et l'entrée de déclenchement de TDC3. Le dipôle est par exemple un capteur de courant.

La sortie de la deuxième bascule de Schmitt BS2 est reliée à l'entrée de déclenchement du quatrième convertisseur temps - numérique TDC4 et à l'entrée d'enclenchement du troisième convertisseur temps - numérique TDC3. Préférentiellement, la sortie de la deuxième bascule de Schmitt BS1 est reliée directement à l'entrée de déclenchement de TDC4 et à l'entrée d'enclenchement de TDC3 en ce sens qu'aucun autre dipôle n'est connecté en série entre BS2 et l'entrée de déclenchement de TDC4, ni entre BS2 et l'entrée d'enclenchement de TDC3. Alternativement, un dipôle est connecté en série entre BS2 et l'entrée de déclenchement de TDC4 ou entre BS2 et l'entrée d'enclenchement de TDC3. Le dipôle est par exemple un capteur de courant.

Le troisième convertisseur temps - numérique TDC3 est configuré pour mesurer une valeur de retard $t_3$ entre le front montant du signal numérique injecté en entrée d'enclenchement et le front descendant du signal numérique injecté en entrée de déclenchement. De manière équivalente, le troisième convertisseur temps - numérique TDC3 est configuré pour mesurer une valeur de retard $t_3$ entre le front descendant du signal numérique injecté en entrée d'enclenchement et le front montant du signal numérique injecté en entrée de déclenchement.

Le quatrième convertisseur temps - numérique TDC4 est configuré pour mesurer une valeur de retard $t_4$ entre le front descendant du signal numérique injecté en entrée de déclenchement et le front montant du signal numérique injecté en entrée d'enclenchement. De manière équivalente, le quatrième convertisseur temps - numérique TDC4 est configuré pour mesurer une valeur de retard $t_4$ entre le front montant du signal numérique injecté en entrée de déclenchement et le front descendant du signal numérique injecté en entrée d'enclenchement.

Comme décrit ci-avant, pour les TDC 1, 2 et 4, le retard $\hat{t}$ entre les fronts montants ou descendant de $\overline{U}_V$, et $\overline{U}_I$ est approximé par $\hat{t} = N\tau$, avec N la position de la bascule où se produit une transition de valeur de sortie de '1' logique à '0' logique. Pour le TDC3, le retard $\hat{t}$ entre le front descendant du signal numérique $\overline{U}_V$ injecté en entrée d'enclenchement ($\overline{U}_V$) et le front montant du signal numérique $\overline{U}_I$ injecté en entrée de déclenchement est approximé par $\hat{t} = N\tau$, avec N la position de la bascule où se produit une transition de valeur de sortie de '0' logique à '1' logique.

Dans ce mode de réalisation, l'unité de calcul UC est configurée pour calculer la valeur de la phase de l'impédance complexe de l'élément électrique EL, soit en fonction de $t_1$ pour $t_1 \leq S_0$, soit en fonction de $t_2$ pour $S_1 \leq t_1 \leq S_2$, soit en fonction de $t_3$ pour $S_0 \leq t_1 \leq S_{0'}$, soit en fonction de $t_4$ pour $S_0 \leq t_1 \leq S_1$, dans lequel $S_0$, $S_{0'}$, $S_1$ et $S_2$ sont quatre valeurs seuil, avec $S_0 \leq S_{0'} \leq S_1 \leq S_2$.

De manière préférentielle, $S_0 = T/4$, $S_{0'} = T/2$, $S_1 = 3T/4$ et $S_2 = T$. Pour $t_1 \leq T/4$, le retard $\hat{t}$ est égal au temps $t_1$. Pour $T/4 \leq t_1 \leq T/2$, la valeur de retard $\hat{t}$ est égale à $(T/2 - t_3)$. Pour $T/2 \leq t_1 \leq 3T/4$, la valeur de retard $\hat{t}$ est égale à $(T/2 + t_4)$. Pour $3T/4 \leq t_1 \leq T$, la valeur de retard $\hat{t}$ est égale à $(T - t_2)$.

Selon une première variante du deuxième mode de réalisation, l'algorithme de mesure pour l'estimation du retard $\hat{t}$ est le suivant :

$$\left(t_1 < \frac{T}{4}\right) \rightarrow \hat{t} = t_1$$

$$\left(t_1 > \frac{T}{4}\right) \& \left(t_1 < \frac{T}{2}\right) \rightarrow \hat{t} = \frac{T}{2} - t_3$$

$$\left(t_1 > \frac{T}{2}\right) \& \left(t_1 < \frac{3T}{4}\right) \rightarrow \hat{t} = \frac{T}{2} + t_4$$

$$\left(t_1 > \frac{3T}{4}\right) \rightarrow \hat{t} = T - t_2$$

Selon la première variante du deuxième mode de réalisation, le TDC 1 doit pouvoir mesurer une valeur de retard allant jusqu'à au $T_{max}$ tandis que les TDC 2, 3 et 4 doivent pouvoir mesurer une valeur de retard allant jusqu'à $T_{max}/4$.

Avantageusement, le retard $t_1$, $t_2$, $t_3$ ou $t_4$ utilisé pour l'évaluation du retard $\hat{t}$ est toujours inférieur à 90° pour une fréquence du premier signal numérique $\overline{U}_V$ égale à $\boldsymbol{f_{min}}$. Le retard t mesuré peut être supérieur à 90° si la fréquence du premier signal numérique $\overline{U}_V$ est supérieure à $\boldsymbol{f_{min}}$. Cela permet de limiter la complexité des TDC utilisés, en particulier en termes de nombre d'éléments de retard, et de diminuer l'erreur sur l'estimation de la phase de l'impédance de l'élément électrique EL. L'invention permet également de rendre plus symétrique en phase l'erreur sur l'estimation de la phase de l'impédance de l'élément électrique EL.

Selon une deuxième variante du deuxième mode de réalisation, le convertisseur temps-numérique TDC1 (respectivement TDC2, TDC3) est configuré pour renvoyer une valeur nulle lorsque la valeur de retard mesurée $t_1$ (respectivement $t_2$, $t_3$) est supérieure au quart de la période du premier signal numérique $\overline{U}_V$. La valeur de la phase de l'impédance complexe de l'élément électrique est déterminée, soit en fonction de la valeur de retard $t_1$ pour $t_1 < T/4$, soit en fonction de $t_3$ pour ($t_1 > T/4$ ou $t_1 = 0$) et $t_3 < T/4$, soit en fonction de $t_4$ pour ($t_1 > T/4$ ou $t_1 = 0$), ($t_3 > T/4$ ou $t_3 = 0$) et $t_4 < T/4$, soit en fonction de $t_2$ pour ($t_1 > T/4$ ou $t_1 = 0$), ($t_3 > T/4$ ou $t_3 = 0$), ($t_4 > T/4$ ou $t_4 = 0$) et $t_2 < T/4$.

Selon la deuxième variante du deuxième mode de réalisation, l'algorithme de mesure pour l'estimation du retard $\hat{t}$ est le suivant :

$$\left(t_1 < \frac{T}{4}\right) \rightarrow \hat{t} = t_1$$

$$\left(\left(t_1 > \frac{T}{4}\right) | (t_1 == 0)\right) \& \left(t_3 < \frac{T}{4}\right) \rightarrow \hat{t} = \frac{T}{2} - t_3$$

$$\left(\left(t_1 > \frac{T}{4}\right) | (t_1 == 0)\right) \& \left(\left(t_3 > \frac{T}{4}\right) \middle| (t_3 == 0)\right) \& (t_4 < \frac{T}{4}) \rightarrow \hat{t} = \frac{T}{2} + t_4$$

$$\left(\left(t_1 > \frac{T}{4}\right) | (t_1 == 0)\right) \& \left(\left(t_3 > \frac{T}{4}\right) \middle| (t_3 == 0)\right) \& \left(\left(t_4 > \frac{T}{4}\right) \middle| (t == 0)\right) \rightarrow \hat{t} = T - t_2$$

Selon la deuxième variante du deuxième mode de réalisation, tous les TDC doivent seulement pouvoir mesurer une valeur de retard allant jusqu'à $T_{max}/4$. Avantageusement, cela permet de réduire la complexité des TDC utilisés.

Les convertisseurs temps-numérique TDC1, TDC2, TDC3 sont ainsi d'une complexité moindre car leur gamme de mesure est de 0° à 90°.

L'invention concerne également un procédé de mesure de la phase d'une impédance complexe d'un élément électrique EL. Le procédé peut être mis en œuvre par un appareil selon un des modes de réalisations précédemment décrits.

Selon un premier mode de réalisation de l'invention, le procédé comprend les étapes suivantes :

une étape d'excitation S11 durant laquelle un signal d'excitation $S_{ex}$ oscillant à une période T connue est appliqué à l'élément électrique EL ;

une premier étape d'acquisition S21 durant laquelle un premier signal analogique $u_v$, variable au cours du temps, et représentatif d'une tension aux bornes de l'élément électrique EL est acquis ;

une deuxième étape d'acquisition S22 durant laquelle un deuxième signal analogique $u_i$, variable au cours du temps, et représentatif d'un courant à travers l'élément électrique EL est acquis ;

une étape de numérisation S31 durant laquelle le premier signal analogique $u_v$ est numérisé en un premier signal numérique $\overline{U}_V$ et le deuxième signal analogique ($u_i$) est numérisé en un second signal numérique $\overline{U}_I$ ;

une première étape d'injection S41 durant laquelle le premier signal numérique $\overline{\overline{U}_V}$ est injecté en entrée d'enclenchement d'un premier convertisseur temps-numérique et en entrée de déclenchement d'un second convertisseur temps-numérique ;

une deuxième étape d'injection S42 durant laquelle le second signal numérique $\overline{U}_I$ est injecté en entrée de déclenchement du premier convertisseur temps-numérique et en entrée d'enclenchement du second convertisseur temps-numérique ;

une première étape de détermination S51 durant laquelle une première valeur de retard $t_1$ entre le front montant, respectivement descendant, du signal numérique injecté en entrée d'enclenchement et le front montant, respectivement descendant, du signal numérique injecté en entrée de déclenchement du premier convertisseur numérique de retard est déterminée, et une seconde valeur de retard $t_2$ entre le front montant, respectivement descendant, du signal numérique injecté en entrée d'enclenchement et le front montant, respectivement descendant, du signal numérique injecté en entrée de déclenchement du deuxième convertisseur temps-numérique est déterminée ;

une première étape de calcul S61 durant laquelle la valeur de la phase de l'impédance complexe de l'élément électrique est calculée, soit en fonction de $t_1$ pour $t_1 \leq S_0$, soit en fonction de $t_2$ pour $S_1 \leq t_1 \leq S_2$, dans lequel $S_0$, $S_1$ et $S_2$ sont trois valeurs seuil, avec $S_0 \leq S_1 \leq S_2$.

De manière préférentielle, $S_0 = S_1 = T/2$ et $S_2 = T$.

De manière préférentielle, la valeur de retard $t_1$ se voit attribuer une valeur nulle lorsque la valeur de retard mesurée $t_1$ est supérieure à la moitié de la période du premier signal numérique $\overline{U}_V$.

Selon le premier mode de réalisation de l'invention, l'algorithme de mesure pour l'estimation du retard $\hat{t}$ est le suivant :

$$\left(t_1 < \frac{T}{2}\right) \rightarrow \hat{t} = t_1$$

$$\left(t_1 > \frac{T}{2}\right) | (t_1 == 0) \rightarrow \hat{t} = T - t_2$$

Selon un deuxième mode de réalisation de l'invention, le procédé de mesure comprend également :

une troisième étape d'injection S43 durant laquelle le second signal numérique $\overline{U}_I$ est injecté en entrée d'enclenchement d'un troisième convertisseur temps-numérique et en entrée de déclenchement d'un quatrième convertisseur temps-numérique. La troisième étape d'injection S43 se situe après la deuxième étape d'injection S42 et avant la première étape de détermination S51 ;

une quatrième étape d'injection S44 durant laquelle le premier signal numérique $\overline{U}_V$, est injecté en entrée de déclenchement du troisième convertisseur temps-numérique et en entrée d'enclenchement du quatrième convertisseur temps-numérique. La quatrième étape d'injection S44 se situe après la troisième étape d'injection S43 et avant la première étape de détermination S51;

Une deuxième étape de détermination S52 durant laquelle une troisième valeur de retard $t_3$ entre le front montant, respectivement descendant, du signal numérique injecté en entrée d'enclenchement et le front descendant, respectivement montant, du signal numérique injecté en entrée de déclenchement du troisième convertisseur temps-numérique est déterminée, et une quatrième valeur de retard $t_4$ entre le front descendant, respectivement montant, du signal numérique injecté en entrée d'enclenchement et le front montant, respectivement descendant, du signal numérique injecté en entrée de déclenchement du quatrième convertisseur temps-numérique est déterminée;

Une deuxième étape de calcul S62 durant laquelle la valeur de la phase de l'impédance complexe de l'élément électrique est calculée, soit en fonction de $t_3$ pour $S_0 \leq t_1 \leq S_{0'}$, soit en fonction de $t_4$ pour $S_{0'} \leq t_1 \leq S_1$, dans lequel $S_{0'}$ est une valeur seuil, avec $S_0 \leq S_{0'} \leq S_1 \leq S_2$.

De manière préférentielle, $S_0 = T/4$, $S_{0'} = T/2$ et $S_1 = 3T/4$ et $S_2 = T$.

Selon une première variante du deuxième mode de réalisation, l'algorithme de mesure pour l'estimation du retard $\hat{t}$ est le suivant :

$$\left(t_1 < \frac{T}{4}\right) \rightarrow \hat{t} = t_1$$

$$\left(t_1 > \frac{T}{4}\right) \& \left(t_1 < \frac{T}{2}\right) \rightarrow \hat{t} = \frac{T}{2} - t_3$$

$$\left(t_1 > \frac{T}{2}\right) \& \left(t_1 < \frac{3T}{4}\right) \rightarrow \hat{t} = \frac{T}{2} + t_4$$

$$\left(t_1 > \frac{3T}{4}\right) \rightarrow \hat{t} = T - t_2$$

Selon une deuxième variante du deuxième mode de réalisation, les valeurs de retard se voient attribuer une valeur nulle lorsqu'elles sont supérieures à T/4, et dans lequel la valeur de la phase de l'impédance complexe de l'élément électrique est calculée, soit en fonction de la valeur de retard $t_1$ pour $t_1 < T/4$, soit en fonction de $t_3$ pour ($t_1 > T/4$ ou $t_1 = 0$) et $t_2 < T/4$, soit en fonction de $t_4$ pour ($t_1 > T/4$ ou $t_1 = 0$), ($t_3 > T/4$ ou $t_3 = 0$) et $t_4 < T/4$, soit en fonction de $t_2$ pour ($t_1 > T/4$ ou $t_1 = 0$), ($t_3 > T/4$ ou $t_2 = 0$), ($t_4 > T/4$ ou $t_4 = 0$) et $t_2 < T/4$.

Selon la deuxième variante du deuxième mode de réalisation, l'algorithme de mesure pour l'estimation du retard $\hat{t}$ est le suivant :

$$\left(t_1 < \frac{T}{4}\right) \rightarrow \hat{t} = t_1$$

$$\left(\left(t_1 > \frac{T}{4}\right) | (t_1 == 0)\right) \& \left(t_3 < \frac{T}{4}\right) \rightarrow \hat{t} = \frac{T}{2} - t_3$$

$$\left(\left(t_1 > \frac{T}{4}\right) | (t_1 == 0)\right) \& \left(\left(t_3 > \frac{T}{4}\right) \middle| (t_3 == 0)\right) \& (t_4 < \frac{T}{4}) \rightarrow \hat{t} = \frac{T}{2} + t_4$$

$$\left(\left(t_1 > \frac{T}{4}\right) | (t_1 == 0)\right) \& \left(\left(t_3 > \frac{T}{4}\right) \middle| (t_3 == 0)\right) \& \left(\left(t_4 > \frac{T}{4}\right) \middle| (t == 0)\right) \rightarrow \hat{t} = T - t_2$$

L'invention a été décrite en référence à des modes de réalisation particuliers, mais des variantes sont possibles. Par exemple :

Les valeurs de seuils peuvent être $S_0$=T/3, $S_{0'}$=T/2 et $S_1$=2T/3 et $S_2$=T.

Avantageusement, une telle configuration avec des plages de mesures non symétriques entre chaque TDC (dans cette variante, les plages de mesures de TDC3 et TDC4 seraient inférieures aux plages de mesures de TDC1 et TDC2) permettrait l'utilisation de TDC avec un plus grand nombre d'éléments de retard (ou un temps de transition $\tau$ plus petit) pour une plus petite plage de mesure. Cela permettrait de concentrer les éléments de mesure (ou d'utiliser les éléments de mesure ayant les temps de transition $\tau$ les plus petits) aux intervalles les plus pertinents et de prendre en compte plus efficacement l'asymétrie de l'erreur de mesure de phase en fonction de la phase décrite ci-avant et montrée à la [Fig. 4], tout en limitant le nombre total d'éléments de mesure sur l'intervalle [0°-360°]. D'autres valeurs de seuils peuvent être choisies pour mieux tenir compte du comportement des TDC utilisés et des bandes de fréquence utilisées pour la mesure de l'impédance.

L'appareil peut être intégré dans un système ASIC (ou « Application-Specific Integrated Circuit » selon l'appellation anglo-saxonne couramment utilisée).

Références

(Mattada et al. 2021): M. Mattada, H. Guhilot, 62.5 ps LSB resolution multiphase clock Time to Digital Converter (TDC) implemented on FPGA, Journal of King Saud Université - Engineering Sciences, Volume 34, Issue 6, 2022, Pages 418-424.

**Revendications**

1. Appareil de mesure de la phase d'une impédance complexe d'un élément électrique (EL) comprenant :

    - une première bascule de Schmitt (BS1) configurée pour recevoir en entrée un premier signal analogique ($u_v$), variable au cours du temps, de période T, représentatif d'une tension entre deux bornes de l'élément électrique, et le convertir en un premier signal numérique ($\overline{U}_V$) ;
    - une deuxième bascule de Schmitt (BS2) configurée pour recevoir un deuxième signal analogique ($u_I$), variable au cours du temps, représentatif d'un courant à travers l'élément électrique, et le convertir en un deuxième signal numérique ($\overline{U}_I$) ;
    - un premier convertisseur temps - numérique (TDC1) ;
    - un deuxième convertisseur temps - numérique (TDC2) ;
    - une unité de calcul (UC) ;
    la sortie de la première bascule de Schmitt (BS1) étant reliée, directement ou indirectement, à l'entrée d'enclenchement du premier convertisseur temps - numérique (TDC1) et à l'entrée de déclenchement du second convertisseur temps - numérique (TDC2),
    la sortie de la deuxième bascule de Schmitt (BS2) étant reliée, directement ou indirectement, à l'entrée de déclenchement du premier convertisseur temps - numérique (TDC1) et à l'entrée d'enclenchement du second convertisseur temps - numérique (TDC2),
    le premier convertisseur temps - numérique (TDC1) étant configuré pour mesurer une valeur de retard $t_1$ entre le front montant, respectivement descendant, du signal numérique injecté en entrée d'enclenchement et le front montant, respectivement descendant, du signal numérique injecté en entrée de déclenchement,
    le deuxième convertisseur temps - numérique (TDC2) étant configuré pour mesurer une valeur de retard $t_2$ entre le front montant, respectivement descendant, du signal numérique injecté en entrée de déclenchement et le front montant, respectivement descendant, du signal numérique injecté en entrée d'enclenchement,
    l'unité de calcul (UC) étant configurée pour calculer la valeur de la phase de l'impédance complexe de l'élément électrique, soit en fonction de $t_1$ pour $t_1 \leq S_0$, soit en fonction de $t_2$ pour $S_1 \leq t_1 \leq S_2$, dans lequel $S_0$, $S_1$ et $S_2$ sont trois valeurs seuil, avec $S_0 \leq S_1 \leq S_2$.

2. Appareil selon la revendication 1, dans lequel $S_0 = S_1 = T/2$ et $S_2 = T$.

3. Appareil de mesure de la phase d'une impédance complexe d'un élément électrique (EL) selon la revendication 2, comprenant en outre :

- un troisième convertisseur temps - numérique (TDC3) ;
- un quatrième convertisseur temps - numérique (TDC4) ;

la sortie de la première bascule de Schmitt (BS1) étant reliée, directement ou indirectement, à l'entrée d'enclenchement du quatrième convertisseur temps - numérique (TDC4) et à l'entrée de déclenchement troisième convertisseur temps - numérique (TDC3),

la sortie de la deuxième bascule de Schmitt (BS2) étant reliée, directement ou indirectement, à l'entrée d'enclenchement du troisième convertisseur temps - numérique (TDC3) et à l'entrée de déclenchement du quatrième convertisseur temps - numérique (TDC4),

le troisième convertisseur temps - numérique (TDC3) étant configuré pour mesurer une valeur de retard $t_3$ entre le front montant, respectivement descendant, du signal numérique injecté en entrée d'enclenchement et le front descendant, respectivement montant, du signal numérique injecté en entrée de déclenchement,

le quatrième convertisseur temps - numérique (TDC4) étant configuré pour mesurer une valeur de retard $t_4$ entre le front descendant, respectivement montant, du signal numérique injecté en entrée d'enclenchement et le front montant, respectivement descendant, du signal numérique injecté en entrée de déclenchement,

l'unité de calcul (UC) étant configurée pour calculer la valeur de la phase de l'impédance complexe de l'élément électrique, soit en fonction de $t_3$ pour $S_0 \leq t_1 \leq S_{0'}$, soit en fonction de $t_4$ pour $S_{0'} \leq t_1 \leq S_1$, dans lequel $S_{0'}$ est une valeur seuil, avec $S_0 \leq S_{0'} \leq S_1 \leq S_2$.

4. Appareil selon la revendication 3, dans lequel $S_0 = T/4$, $S_{0'} = T/2$, $S_1 = 3T/4$ et $S_2 = T$.

5. Appareil selon la revendication 4, dans lequel les convertisseurs temps-numérique sont configurés pour renvoyer une valeur nulle lorsque la valeur de retard mesurée est supérieure à T/4, et dans lequel la valeur de la phase de l'impédance complexe de l'élément électrique est déterminée, soit en fonction de la valeur de retard $t_1$ pour $t_1 < T/4$, soit en fonction de $t_3$ pour ($t_1 > T/4$ ou $t_1 = 0$) et $t_3 < T/4$, soit en fonction de $t_4$ pour ($t_1 > T/4$ ou $t_1 = 0$), ($t_3 > T/4$ ou $t_3 = 0$) et $t_4 < T/4$, soit en fonction de $t_2$ pour ($t_1 > T/4$ ou $t_1 = 0$), ($t_3 > T/4$ ou $t_3 = 0$), ($t_4 > T/4$ ou $t_4 = 0$) et $t_2 < T/4$.

6. Appareil selon l'une quelconque des revendications 1 à 5, dans lequel l'appareil est intégré dans un système FPGA.

7. Procédé de mesure de la phase d'une impédance complexe d'un élément électrique (EL) comprenant les étapes suivantes :

a) appliquer à l'élément électrique (EL) un signal d'excitation ($S_{ex}$) oscillant à une période T connue ;
b) acquérir un premier signal analogique ($u_V$), variable au cours du temps, représentatif d'une tension aux bornes de l'élément électrique ;
c) acquérir un deuxième signal analogique ($u_I$), variable au cours du temps, représentatif d'un courant à travers l'élément électrique ;
d) numériser le premier signal analogique ($u_V$) en un premier signal numérique ($\overline{U}_V$) et le deuxième signal analogique ($u_I$) en un second signal numérique ($\overline{U}_I$);
e) injecter le premier signal numérique ($\overline{U}_V$) en entrée d'enclenchement d'un premier convertisseur temps-numérique et en entrée de déclenchement d'un second convertisseur temps-numérique ;
f) injecter le second signal numérique ($U_I$) en entrée de déclenchement du premier convertisseur temps-numérique et en entrée d'enclenchement du second convertisseur temps-numérique ;
g) déterminer une première valeur de retard $t_1$ entre le front montant, respectivement descendant, du signal numérique injecté en entrée d'enclenchement et le front montant, respectivement descendant, du signal numérique injecté en entrée de déclenchement du premier convertisseur numérique de retard, et une seconde valeur de retard $t_2$ entre le front montant, respectivement descendant, du signal numérique injecté en entrée d'enclenchement et le front montant, respectivement descendant, du signal numérique injecté en entrée de déclenchement du deuxième convertisseur temps-numérique ;
h) calculer la valeur de la phase de l'impédance complexe de l'élément électrique, soit en fonction de $t_1$ pour $t_1 \leq S_0$, soit en fonction de $t_2$ pour $S_1 \leq t_1 \leq S_2$, dans lequel $S_0$, $S_1$ et $S_2$ sont trois valeurs seuil, avec $S_0 \leq S_1 \leq S_2$.

8. Procédé selon la revendication 7, dans lequel $S_0 = S_1 = T/2$ et $S_2 = T$.

9. Procédé selon la revendication 7, comprenant en outre les étapes suivantes :

i) injecter le second signal numérique ($\overline{U}_I$) en entrée d'enclenchement d'un troisième convertisseur temps-numérique et en entrée de déclenchement d'un quatrième convertisseur temps-numérique;

j) injecter le premier signal numérique ($\overline{U}_V$) en entrée de déclenchement du troisième convertisseur temps-numérique et en entrée d'enclenchement du quatrième convertisseur temps-numérique;

k) déterminer une troisième valeur de retard $t_3$ entre le front montant, respectivement descendant, du signal numérique injecté en entrée d'enclenchement et le front descendant, respectivement montant, du signal numérique injecté en entrée de déclenchement du troisième convertisseur temps-numérique, et une quatrième valeur de retard $t_4$ entre le front descendant, respectivement montant, du signal numérique injecté en entrée d'enclenchement et le front montant, respectivement descendant, du signal numérique injecté en entrée de déclenchement du quatrième convertisseur temps-numérique ;

l) calculer la valeur de la phase de l'impédance complexe de l'élément électrique, soit en fonction de $t_3$ pour $S_0 \le t_1 \le S_{0'}$, soit en fonction de $t_4$ pour $S_{0'} \le t_1 \le S_1$, dans lequel $S_{0'}$ est une valeur seuil, avec $S_0 \le S_{0'} \le S_1 \le S_2$.

10. Procédé selon la revendication 9, dans lequel, $S_0 = T/4$, $S_{0'} = T/2$ et $S_1 = 3T/4$ et $S_2 = T$.

11. Procédé selon la revendication 10, dans lequel les valeurs de retard se voient attribuer une valeur nulle lorsqu'elle sont supérieures à $T/4$, et dans lequel la valeur de la phase de l'impédance complexe de l'élément électrique est déterminée, soit en fonction de la valeur de retard $t_1$ pour $t_1 < T/4$, soit en fonction de $t_3$ pour ($t_1 > T/4$ ou $t_1 = 0$) et $t_3 < T/4$, soit en fonction de $t_4$ pour ($t_1 > T/4$ ou $t_1 = 0$), ($t_3 > T/4$ ou $t_3 = 0$) et $t_4 < T/4$, soit en fonction de $t_2$ pour ($t_1 > T/4$ ou $t_1 = 0$), ($t_3 > T/4$ ou $t_3 = 0$), ($t_4 > T/4$ ou $t_4 = 0$) et $t_2 < T/4$.

[Fig. 1]

[Fig. 2]

[Fig. 3]

[Fig. 4]

Erreur sur l'estimation de la phase

[Fig. 5]

[Fig. 6]

Europäisches
Patentamt

European
Patent Office

Office européen
des brevets

## RAPPORT DE RECHERCHE EUROPEENNE

Numéro de la demande

**EP 25 20 4836**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 7 932 847 B1 (HSIEH HONG-YEAN [US] ET AL) 26 avril 2011 (2011-04-26) * le document en entier * ----- | 1-11 | INV. G01R25/00 |
| A | WO 2019/057017 A1 (RADIAWAVE TECH CO LTD [CN]) 28 mars 2019 (2019-03-28) * le document en entier * ----- | 1-11 | |
| A | US 2015/188553 A1 (FAMILIA NOAM [IL] ET AL) 2 juillet 2015 (2015-07-02) * le document en entier * ----- | 1-11 | |

|  | DOMAINES TECHNIQUES RECHERCHES (IPC) |
|---|---|
|  | G01R |

Le présent rapport a été établi pour toutes les revendications

| Lieu de la recherche | Date d'achèvement de la recherche | Examinateur |
|---|---|---|
| Munich | 27 janvier 2026 | Nguyen, Minh |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons
...........................................................................................
& : membre de la même famille, document correspondant

EPO FORM 1503 03.82 (P04C02)

**EP 4 729 952 A1**

## ANNEXE AU RAPPORT DE RECHERCHE EUROPEENNE
## RELATIF A LA DEMANDE DE BREVET EUROPEEN NO.

EP 25 20 4836

27-01-2026

| Document brevet cité au rapport de recherche | | Date de publication | Membre(s) de la famille de brevet(s) | | Date de publication |
|---|---|---|---|---|---|
| US 7932847 | B1 | 26-04-2011 | TW | 201141074 A | 16-11-2011 |
| | | | US | 7932847 B1 | 26-04-2011 |
| WO 2019057017 | A1 | 28-03-2019 | CN | 107577139 A | 12-01-2018 |
| | | | WO | 2019057017 A1 | 28-03-2019 |
| US 2015188553 | A1 | 02-07-2015 | AUCUN | | |

EPO FORM P0460

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• US 7932847 B1

**Littérature non-brevet citée dans la description**

• **M. MATTADA** ; **H. GUHILOT**. 62.5 ps LSB resolution multiphase clock Time to Digital Converter (TDC) implemented on FPGA. *Journal of King Saud Université - Engineering Sciences*, 2022, vol. 34 (6), 418-424